# EUROPÄISCHE PATENTSCHRIFT

(11) **EP 2 143 537 B1**
(45) Veröffentlichungstag und Bekanntmachung des Hinweises auf die Patenterteilung: **08.02.2012**
(21) Anmeldenummer: 09008877.4
(22) Anmeldetag: 07.07.2009
(51) Int. Cl.: B28D 5/00, H01L 21/00

(54) **Verfahren und Vorrichtung zum Brechen von Halbleiterscheiben oder ähnlichen Substraten**
Method and device for breaking semiconductor discs or similar substrates
Procédé et dispositif de rupture de plaques semi-conductrices ou de substrats analogues

(30) Priorität: 07.07.2008 DE 102008031619
(43) Veröffentlichungstag der Anmeldung: 13.01.2010
(73) Patentinhaber: Asys Automatisierungssysteme GmbH, 89160 Dornstadt (DE)
(72) Erfinder: Lindner, Jörg, 83224 Grassau (DE)
(74) Vertreter: Gleiss & Grosse

(56) Entgegenhaltungen:
- WO-A-95/19247
- JP-A- 61 034 955

## Beschreibung

Die Erfindung betrifft ein Verfahren und eine Vorrichtung zum Brechen von Halbleiterscheiben bzw. Wafern sowie Keramik- und Glasscheiben oder ähnlichen Substraten nach den Merkmalen des Oberbegriffs des Anspruchs 1 bzw nach den Merkmalen des Oberbegriffs des Anspruchs 8. Die Oberbegriffe werden von EP 0740 598 B1 offenbart.

Als Wafer (engl. "Scheibe") wird in der Halbleiterindustrie und Mikroelektronik eine kreisrunde, ca. 25 bis 300 µm dicke Scheibe bezeichnet, auf der elektronische Bauelemente, vor allem integrierte Schaltkreise (IC, "Chip") oder mikromechanische Bauelemente durch verschiedene technische Verfahren hergestellt werden.

Diese Scheibe besteht in den meisten Fällen aus monokristallinem Silizium, es werden aber auch andere Materialien wie Siliziumcarbid, Gallium-Arsenid und Indium-Phosphid verwendet. In der Mikrosystemtechnik werden auch Glaswafer mit einer Dicke im 1-mm-Bereich verwendet.

Die Scheiben werden in verschiedenen Durchmessern gefertigt. Die zur Zeit hauptsächlich verwendeten Waferdurchmesser unterscheiden sich je nach Halbleiterwerkstoff und vorgesehenem Verwendungszweck und liegen für Silizium z. B. bei 150 mm, 200 mm, 300 mm und künftig auch bei 450 mm, für Gallium-Arsenid bei 2 Zoll, 3 Zoll, 100 mm, 125 mm oder 150 mm. Je größer der Wafer, desto mehr integrierte Schaltkreise, auch Chips genannt, können darauf untergebracht werden. Da bei größeren Wafern der geometrische Verschnitt kleiner wird, können die integrierten Schaltkreise kostengünstiger produziert werden.

Da für die Verarbeitung der Wafer die exakte Position in der bearbeitenden Maschine wichtig ist, werden die Wafer mit so genannten Flats gekennzeichnet. Dabei wird mit Hilfe eines primären und eventuell einem sekundären Flat angezeigt, welche Winkelorientierung vorliegt und welche Kristallorientierung die Oberfläche hat. In neuerer Zeit werden an Stelle der Flats Kerben, so genannte Notches, eingesetzt. Sie bieten den Vorteil der besseren Positionierung und verursachen vor allem weniger Verschnitt.

Um die einzelnen Schaltkreise voneinander zu trennen, werden die Halbleiterscheiben mit Hilfe bereits bekannter Verfahren und Vorrichtungen zunächst in einzelnen Streifen unterteilt. Dabei werden die jeweiligen Trennlinien vorab mittels eines Diamantstichels an der Oberseite der Halbleiterscheibe durch eingeritzte Kerben entsprechend markiert. Bei der beispielsweise aus der aus EP 0 740 598 B1 bekannten Vorrichtung drückt anschließend ein Impulsstab an der insoweit vorbereiteten Sollbruchlinie von der Unterseite gegen die Halbleiterscheibe, deren Oberseite sich an einem Amboss abstützt. Da bei der bekannten Vorrichtung Impulsstab und Amboss direkt übereinander angeordnet sind, muss der seitens des Impulsstabes ausgeübte Druck ausreichend groß sein, um gegen den Druck des Ambosses einen kontrollierten Trennvorgang auszulösen. Ist der Druck zu gering besteht die Gefahr, dass keine ausreichende und vollständige Trennung erreicht werden kann. Es bedarf deshalb einer hohen Präzision hinsichtlich des Anpressdruckes, um eine möglichst geringe Trennfehlerquote zu gewährleisten.

Bei der aus W02007/112983 bekannten Vorrichtung zum Brechen von Halbleiterscheiben sind als Gegenelement zu dem von der Unterseite gegen die Sollbruchlinie drückenden Brechkeil zwei auf der Oberseite in seitlichem Abstand zur Sollbruchlinie positionierbare Gegenhalter vorgesehen. Da die Gegenhalter nicht fluchtend zum Brechkeil, sondern seitlich versetzt positioniert sind, lässt sich die Trennung mit einem vergleichbar geringeren Anpressdruck realisieren mit der Folge, dass die Fehlerquote entsprechend reduziert werden kann.

Der vorliegenden Erfindung liegt nun die Aufgabe zugrunde, ein Verfahren und eine Vorrichtung der eingangs genannten Art so zu verbessern, dass für die Vielzahl der über den gesamte Wafergeometrie verteilten Sollbruchlinien mit ihren je nach Substratform unterschiedlichen Längen eine möglichst fehlerfreie und sichere Trennung gewährleistet werden kann.

Diese Aufgabe wird erfindungsgemäß durch ein Verfahren mit den Merkmalen des Anspruchs 1 bzw. durch eine Vorrichtung nach Anspruch 8 gelöst. Der wesentliche Kern der Erfindung besteht dabei in einer derartigen Steuerung des Brechkeils, dass sein Anpressdruck in Abhängigkeit von der geometrischen Form des Substrats wahlweise konstant oder dynamisch auf variable Werte einstellbar ist. Auf diese Weise lässt sich eine für alle Sollbruchlinien eines Wafers weitgehend gleiche Trennqualität erzielen.

Vorteilhafte Weiterbildungen der Erfindung ergeben sich aus den Merkmalen der Unteransprüche.

Ein Ausführungsbeispiel der Erfindung wird im Folgenden an Hand einer beispielhaften Vorrichtung sowie drei in der Zeichnung dargestellten Flussdiagrammen für mittels der Vorrichtung durchführbare Verfahrensweisen näher beschrieben. Dabei zeigen:
Figur 1: ein Flussdiagramm für einen Brechprozess bei Substraten oder Substratteilen mit vergleichsweise großen Abmessungen,
Figur 2: ein Flussdiagramm für die Vorgehensweise bei extrem sensiblen Substraten unter Anwendung eines so genannten Doppelbruch-Modus
Figur 3: ein Flussdiagramm für die Vorgehensweise bei extrem sensiblen Substraten unter Anwendung eines so genannten Overdrive-Modus.

Eine herkömmliche Vorrichtung zur Brechung von Halbleitersubstraten oder dergleichen besteht im Prinzip aus einer Halterung für das Substrat, einem von der Unterseite gegen das Substrat andrückbaren Brechkeil und wenigstens einem auf der Oberseite aufsetzbaren Gegenhalter. Mittels der rahmenartig ausgebildeten Halterung wird das Substrat an seinen Randbereichen, vorzugsweise mittels eines durch Ansaugdüsen realisierten Unterdrucks fixiert. Mittels einer Relativbewegung zwischen Substrat und Brechkeil ist der Brechkeil schrittweise auf eine von mehreren jeweils parallel verlaufenden Sollbruchlinien ausrichtbar. Ferner ist zur Einstellung des für die jeweils aktuelle Sollbruchlinie notwendigen Anpressdrucks eine Steuerungseinheit vorgesehen, die auf der Grundlage substratspezifischer Kenndaten einen eine möglichst optimale Trennung gewährleistenden Druckwert festlegt.

Für unterschiedlich große und gegebenenfalls in ihrer geometrischen Form unterschiedliche Substrate werden erfindungsgemäß entsprechend angepasste Steuerungsprogramme verwendet, die im Folgenden an Hand der in der Zeichnung dargestellten Flussdiagramme näher beschrieben werden.

In den Figuren bezeichnet

| | |
|---|---|
| i | Index für das Brechen (Strassenabstand/Chipgröße) |
| j | Index für das duale Brechen (Strassenabstand/Chipgröße) |
| BN | Bruchnummer |
| O.Drive | Overdrive |

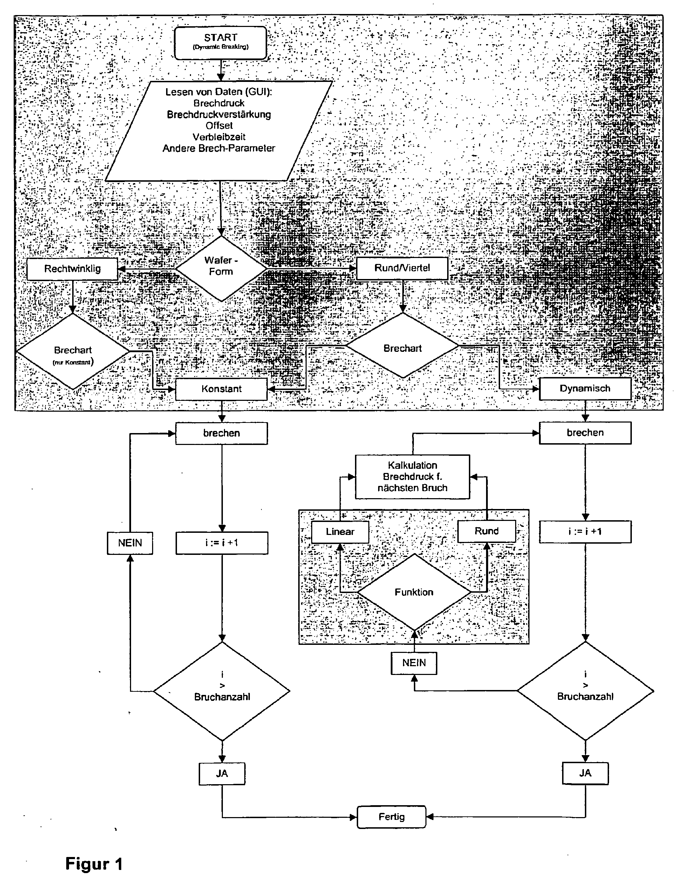

Die Figur 1 zeigt das Flussdiagramm für vergleichsweise große Substrate bzw. Substratteilflächen. Nach der Montage eines Substrats auf der Brechvorrichtung werden zunächst in einer vorprozessualen Phase verschiedene Kenndaten des jeweiligen Substrats manuell eingegeben oder automatisch erfasst und aus den insoweit ermittelten Kenndaten Stellgrößen für den nachfolgenden Brechprozess generiert. Der obere Teil des Flussdiagramms zeigt diesen Vorprozess, bei dem nach dem Start und der Erfassung der substratspezifischen Kenndaten sowie aus daraus generierten Stellgrößen zunächst eine Unterscheidung hinsichtlich der geometrischen Form des Substrats stattfindet, und zwar für Rechteckformen einerseits und Rundformen bzw. Halb- oder Vierteilkreisen andererseits. Diese Unterscheidung bestimmt den jeweiligen Brechmodus derart, dass für die Recheckformen ein Modus mit einem für alle Sollbruchlinien konstanten Anpressdruck für den Brechkeil und für die Rundformen ein dynamischer Modus mit variablen Anpressdruckwerten gewählt werden kann. Bei weniger kritischen Anwendungen kommt für Rundformen auch der vergleichsweise einfachere Modus mit konstantem Anpressdruck in Betracht. Wie der linke untere Teil des Flussdiagramms zeigt, wird der Bruch je nach der Zahl der maximal möglichen Trennlinien in entsprechend vielen Wiederholungsschritten bis zur letzten Sollbruchlinie mit stets gleichem Anpressdruck durchgeführt. Die für die einzelnen Sollbruchlinien maßgeblichen Betriebsparameter sind beispielsweise ein aus den Kenndaten vorab generierter konstanter Basisdruckwert oder der ebenfalls im Vorprozess festgestellte Abstand i zwischen benachbarten Sollbruchlinien. Mit der letzten Sollbruchlinie wird der Brechprozess automatisch beendet, sofern nicht ein vorheriger Abbruch mit der Möglichkeit einer späteren Fortsetzung ausgelöst worden ist.

Für den im rechten Teil dargestellten dynamischen Modus, der für kreisrunde Substratflächen oder für Kreishälften oder Kreisquadranten gewählt werden kann, erfolgt der erste Brechvorgang an der bei derartigen Substratformen vorzugsweise am Rand auftretenden, kürzesten Sollbruchlinie und zwar mit einem auf Grund der Kenndaten generierten Basisdruckwert. Danach erfolgt in einer Relativbewegung zwischen Substrat und Brechkeil, gesteuert durch den aus den Kenndaten bekannten Abstand i zwischen benachbarten Sollbruchlinien, eine Ausrichtung des Brechkeils auf die jeweils nächste Sollbruchlinie. i + 1. Für diese nächste Sollbruchlinie, die bedingt durch die geometrische Form des Substrats eine größere Länge aufweist, wird nun über eine lineare oder nichtlineare, vorzugsweise logarithmische Funktion ein neuer im Vergleich zum Basisdruckwert höherer Anpressdruckwert errechnet und bei dieser nächsten Sollbruchlinie verwendet. Diese Vorgehensweise wird wegen der immer längeren Sollbruchlinien mit jeweils neu errechneten zunehmend höheren Anpressdruckwerten so lange fortgesetzt, bis die längste Sollbruchlinie erreicht ist. Da bei Substraten, die eine Kreis- oder Halbkreisform aufweisen, die nächstfolgenden Sollbruchlinien wieder kürzere Längen aufweisen werden, ergeben sich bei der Neuberechnung der Anpressdruckes dementsprechend auch wieder niedrigere Werte mit fallender Tendenz, bis die letzte und kürzeste Sollbruchlinie erreicht ist. Analog zum Modus mit konstantem Druckwert wird auch hier der Ablauf mit der Trennung an der jeweils letzten Sollbruchlinie automatisch beendet.

Bei extrem sensiblen Substraten, bei denen auf Grund ihrer spezifischen Anwendung nicht über die gesamte Länge, sondern nur in einem relativ kurzen Randbereich angeritzt wird, setzt der Brechkeil von der Unterseite des Substrats auch nur in diesem Randbereich an. Die auf diese Weise durchführbare Trennung auf der gesamten Länge der Sollbruchlinie führt zwar generell zu guten Ergebnissen, dennoch besteht das Bedürfnis, die Qualität des Bruchs durch geringere mechanische Belastung weiter zu verbessern. Dies lässt sich mit einem so genannten Dual-Bruchverfahren dadurch erreichen, dass der initiale Defekt zunächst durch einen ersten kräftigeren Stoß seitens des Brechkeils erzeugt wird. Anschließend erfolgt dann nach einer einstellbaren Verweildauer noch ein zweiter Stoß mit hinsichtlich Druck, Geschwindigkeit usw. geänderten Parametern, der den Bruch weiter entlang der Kristallstruktur des Substrats mit möglichst geringer Materialbeanspruchung fortsetzt.

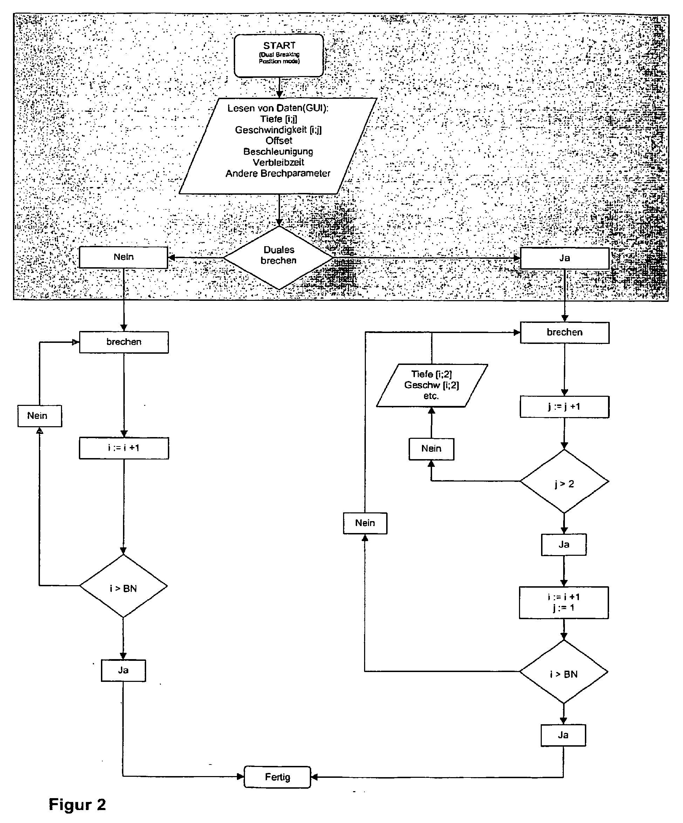

Nähere Einzelheiten für diese Vorgehensweise ergeben sich aus dem in Figur 2 ersichtlichen Flussdiagramm. Auch hier gibt es zunächst nach der Montage eines Substrats auf der Brechvorrichtung eine vorprozessuale Phase, bei der verschiedene Kenndaten des jeweiligen Substrats manuell eingegeben oder automatisch erfasst und aus den insoweit ermittelten Kenndaten Stellgrößen für den nachfolgenden Brechprozess generiert werden. Abhängig von diesen Stellgrößen wird entschieden, ob es bei einem einfachen Bruch bleibt oder ob ein Dual-Bruchverfahren durchgeführt wird. Wie der linke untere Teil des Flussdiagramms zeigt, erfolgt der Brechvorgang mit einem stets gleichen Anpressdruck in den durch den Abstand i zwischen benachbarten Sollbruchlinien vorgegebenen Wiederholungsphasen, bis die letzte Sollbruchlinie erreicht ist und der gesamte Brechvorgang automatisch beendet wird.

Bei einer Entscheidung zu Gunsten des Dual-Bruchverfahrens erfolgt zunächst ein erster kräftiger Stoß mit einem vorgegebenen Anpressdruck. Anschließend wird die aktuelle Zahl j der stattgefundenen Bruchvorgänge geprüft und sofern die Zahl kleiner 2 ist, ein erneuter Bruchvorgang eingeleitet. Aus vorab generierten Stellgrößen, u. a. Tiefe und Geschwindigkeit für die Bewegung des Brechkeils, erfolgt nach einer einstellbaren Verweildauer mit geänderten Bruchparametem ein zweiter Stoß. Anschließend wird wieder die Anzahl der durchgeführten Bruchvorgänge gezählt und, da nunmehr zwei Bruchvorgänge stattgefunden haben, der Brechkeil, gesteuert durch den aus den Kenndaten bekannten Abstand i zwischen benachbarten Sollbruchlinien, auf die jeweils nächste Sollbruchlinie. i + 1 ausgerichtet. Dieses Dual-Brechverfahren wird entsprechend der Zahl der vorhandenen Sollbruchlinien durch Wiederholung bis zur letzten Sollbruchlinie fortgesetzt und dann vorzugsweise automatisch beendet.

Eine Variante des an Hand der Figur 2 beschriebenen Dual-Bruchverfahrens ergibt sich durch das so genannten Overdrive-Bruchverfahren. Bei diesem Prozess verursacht der erste Aufprall des Brechkeils einen initialen Defekt am Randbereich des zu brechenden Substrats. Um der Gefahr vorzubeugen, dass eine unmittelbare Weiterführung der Aufwärtsbewegung des Brechkeils das Material des Substrats zu stark belasten würde, wird der Brechkeil unmittelbar nach dem ersten Aufprall angehalten, um ihn kurz in dieser Position verweilen zu lassen, ehe die Aufwärtsbewegung und damit die Weiterführung des Bruchs entlang der Kristallstruktur fortgesetzt wird.

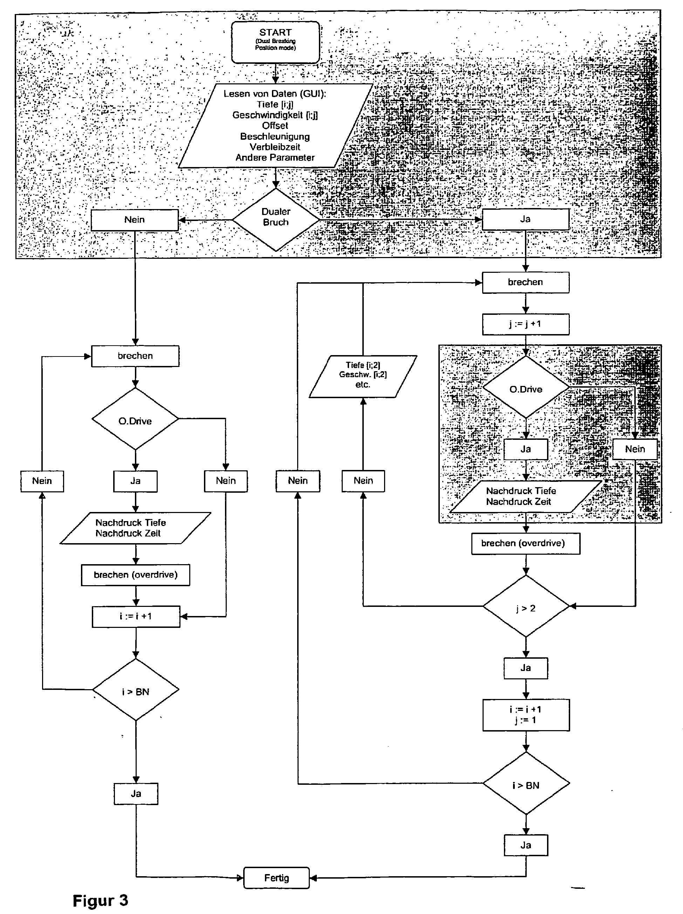

Einzelheiten dieses kombinierten Prozesses ergeben sich aus dem in der Figur 3 dargestellten Flussdiagramms. Im Zuge der vorprozessualen Phase wird wiederum zwischen einem einfachen Bruchverfahren oder einem Dual-Bruchverfahren unterschieden. Bei dem im linken unteren Teil des Diagramms dargestellten einfachen Bruchverfahren wird nach dem durch einen Aufprall des Brechkeils ausgelösten Brechvorgang entschieden, ob zusätzlich ein so genanntes Overdrive-Bruchverfahren durchgeführt wird. Bei einer positiven Entscheidung wird mit neuen Bruchparametem bezüglich Nachdrucktiefe und Nachdruckpausendauer die Aufwärtsbewegung des Brechkeils bis zum vollständigen Bruch fortgesetzt. Anschließend wird der Brechkeil auf die nächste Sollbruchlinie i + 1 ausgerichtet, analog zur Vorgehensweise ohne Overdrive.

Bei einer Entscheidung zu Gunsten des Dual-Bruchverfahrens (siehe den rechten unteren Teil des Flussdiagramms) erfolgt zunächst ein erster kräftiger Stoß mit einem vorgegebenen Anpressdruck. Anschließend wird die aktuelle Zahl j der stattgefundenen Bruchvorgänge geprüft und danach entscheiden, ob ein Overdrive-Bruchverfahren in der bereits beschriebenen Weise durchgeführt wird oder nicht. Daraufhin wird wieder die aktuelle Zahl j der stattgefundenen Bruchvorgänge geprüft und sofern die Zahl kleiner 2 ist, nunmehr im Zuge des Dual-Bruchverfahrens ein erneuter Bruchvorgang, gegebenenfalls auch wieder unter Einbeziehung des Overdrive-Bruchverfahrens, eingeleitet. Anschließend wird wieder die Anzahl der durchgeführten Bruchvorgänge gezählt und, da nunmehr zwei Bruchvorgänge stattgefunden haben, der Brechkeil, gesteuert durch den aus den Kenndaten bekannten Abstand i zwischen benachbarten Sollbruchlinien, auf die jeweils nächste Sollbruchlinie i + 1 ausgerichtet. Dieses Dual-Bruchverfahren mittels Overdrive, wird auch hier wieder entsprechend der Zahl der vorhandenen Sollbruchlinien durch Wiederholung bis zur letzten Sollbruchlinie fortgesetzt und dann vorzugsweise automatisch beendet.

## Patentansprüche

1. Verfahren zum Brechen von Halbleiterscheiben bzw. Wafern, Keramik- und Glasscheiben oder ähnlichen Substraten an jeweils längs einer Gerade verlaufenden Sollbruchlinien, die durch eine Ritzung an der Oberseite der Halbleiterscheibe oder ähnlichen Substraten markiert sind, unter Verwendung eines an der Unterseite der Halbleiterscheibe oder dergleichen fluchtend zur jeweiligen Sollbruchlinie ausgerichteten Brechkeils und wenigstens eines Gegenhalters, der sich auf der Oberseite der Halbleiterscheibe oder dergleichen abstützt und im Augenblick des sich an der Unterseite der Halbleiterscheibe oder dergleichen andrückenden Brechkeils einen Gegendruck auslöst,
**dadurch gekennzeichnet, dass** für das jeweilige Substrat aus dessen substratspezifischen, vorab gespeicherten Kenndaten einzelne Stellgrößen für den Brechkeil generiert werden und dass in Abhängigkeit der substratspezifischen Kenndaten zwischen einem Modus mit einem für alle Sollbruchlinien konstanten Anpressdruck für den Brechkeil und einem Modus mit für jede der einzelnen Sollbruchlinien individuellen variablen Anpressdruckwerten gewählt wird.

2. Verfahren nach Anspruch 1, **dadurch gekennzeichnet, dass** der Anpressdruck stetig und/oder stufenweise veränderbar ist.

3. Verfahren nach Anspruch 2, **dadurch gekennzeichnet, dass** der Anpressdruck in wenigstens zwei zeitlich versetzten Aufprallphasen erzeugt wird.

4. Verfahren nach Anspruch 3, **dadurch gekennzeichnet, dass** zwischen zwei Aufprallphasen eine zeitlich vorgebbare Pause stattfindet.

5. Verfahren nach einem der vorhergehenden Ansprüche, **dadurch gekennzeichnet, dass** der Anpressdruck in Abhängigkeit von der jeweiligen Sollbruchlinie zugeordneten Stellgrößen je nach der jeweiligen Länge der Sollbruchlinie variabel einstellbar ist.

6. Verfahren nach Anspruch 5, **dadurch gekennzeichnet, dass** der Anpressdruck, ausgehend von einem für die kürzeste Sollbruchlinie festegelegten Basisdruckwert, für die jeweils nächstfolgende Sollbruchlinie in Abhängigkeit geänderter Stellgrößen auf einen variablen höheren Wert einstellbar ist.

7. Verfahren nach Anspruch 6, **dadurch gekennzeichnet dass** für runde Substratflächen der Anpressdruck, ausgehend vom Basisdruckwert, bei zunehmender Länge der Sollbruchlinien stufenweise auf höhere Werte und nach einem erreichten Maximalwert bei wiederum abnehmender Länge entsprechend wieder auf niedrigere Werte einstellbar ist.

8. Vorrichtung zum Brechen von Halbleiterscheiben bzw. Wafern, Keramik- und Glasscheiben oder ähnlichen Substraten an jeweils längs einer Gerade verlaufenden Sollbruchlinien, die durch eine Ritzung an der Oberseite der Halbleiterscheibe oder ähnlichen Substraten markiert sind, unter Verwendung eines an der Unterseite der Halbleiterscheibe oder dergleichen fluchtend zur jeweiligen Sollbruchlinie ausgerichteten Brechkeils und wenigstens eines Gegenhalters, der sich auf der Oberseite der Halbleiterscheibe oder dergleichen abstützt und im Augenblick des sich an der Unterseite der Halbleiterscheibe oder dergleichen andrückenden Brechkeils einen Gegendruck auslöst,
**gekennzeichnet durch** eine Anordnung zur Erfassung und Verarbeitung substratspezifischer Kenndaten und **durch** eine in Abhängigkeit von aus Kenndaten abgeleiteten Stellgrößen schaltbare Ansteuereinrichtung für den Brechkeil in der Weise, dass der Anpressdruck für den Brechkeil einerseits auf einen für alle Sollbruchlinien konstanten Wert und andererseits auf für jeweilige Sollbruchlinien variable Werte einstellbar ist.

9. Vorrichtung nach Anspruch 8, **dadurch gekennzeichnet, dass** Substrat und Brechkeil in durch den Abstand benachbarter Sollbruchlinien vorgegebenen Schritten relativ zueinander beweglich gelagert sind.

10. Vorrichtung nach Anspruch 8 oder 9, **dadurch gekennzeichnet, dass** zur Ermittlung der substratspezifischen Messdaten entsprechende Messanordnungen und/oder Sensoren vorgesehen sind, die bezüglich der Relativbewegung zwischen Substrat und Brechkeil so gelagert sind, dass sie jeweils auf die aktuelle Sollbruchlinie ausgerichtet sind.

## Claims

1. A method for breaking semiconductor disks or wafers, respectively, ceramic and glass plates or similar substrates in each case on predetermined breaking lines, which extend along a straight line, and which are marked by scribing on the upper side of the semiconductor disk or similar substrates, using a breaking block, which is positioned on the bottom side of the semiconductor disk or the like so as to be aligned with the respective predetermined breaking line, and at least one counter support, which is supported on the upper side of the semiconductor disk or the like and which triggers a counter pressure at the point in time when the breaking block presses against the bottom side of the semiconductor disk or the like,
**characterized in that** individual variables for the breaking block are generated for the respective substrate from the previously stored substrate-specific characteristics thereof and **in that** a selection is made between a mode with a contact pressure for the breaking block, which is constant for all predetermined breaking lines, and a mode with contact pressure values, which are individually variable for each of the individual predetermined breaking lines, as a function of the substrate-specific characteristics.

2. The method according to claim 1, **characterized in that** the contact pressure can be changed constantly and/or gradually.

3. The method according to claim 2, **characterized in that** the contact pressure is generated in at least two chronologically staggered impact phases.

4. The method according to claim 3, **characterized in that** a chronological pause, which can be predetermined, takes place between two impact phases.

5. The method according to any one of the preceding claims, **characterized in that** the contact pressure can be set variably depending on the respective length of the predetermined breaking line as a function of the variables, which are assigned to the respective predetermined breaking line.

6. The method according to claim 5, **characterized in that** the contact pressure, based on a base pressure value, which is determined for the shortest predetermined breaking line, can be set to a variable higher value for the respective following predetermined breaking line as a function of changed variables.

7. The method according to claim 6, **characterized in that**, based on the base pressure value, the contact pressure for round substrate surfaces can gradually be set to higher values in response to an increasing length of the predetermined breaking lines, and can accordingly be set to lower values again in response to a length, which decreases again, after a maximum value has been reached.

8. A device for breaking semiconductor disks or wafers, respectively, ceramic and glass plates or similar substrates in each case on predetermined breaking lines, which extend along a straight line, and which are marked by scribing on the upper side of the semiconductor disk or similar substrates, using a breaking block, which is positioned on the bottom side of the semiconductor disk or the like so as to be aligned with the respective predetermined breaking line, and at least one counter support, which is supported on the upper side of the semiconductor disk or the like and which triggers a counter pressure at the point in time when the breaking block presses against the bottom side of the semiconductor disk or the like,
**characterized by** an arrangement for detecting and processing substrate-specific characteristics and by a control device, which can be switched as a function of variables, which are derived from characteristics, for the breaking block in such a manner that the contact pressure for the breaking block on the one hand can be set to a value, which is constant for all predetermined breaking lines, and, on the other hand, to a value, which is variable for respective predetermined breaking lines.

9. The device according to claim 8, **characterized in that** substrate and breaking block are supported so as to be moveable relative to one another in steps, which are predetermined by the distance of adjacent predetermined breaking lines.

10. The device according to claim 8 or 9, **characterized in that**, for determining the substrate-specific measuring data, provision is made for corresponding measuring configurations and/or sensors, which are supported in such a manner with reference to the relative movement between substrate and breaking block that they are in each case oriented towards the current predetermined breaking line.

## Revendications

1. Procédé de cassure de disques semi-conducteurs ou de plaquettes, disques céramiques et en verre ou substrats similaires sur des lignes destinées à la rupture s'étendant chacune le long d'une droite qui sont marquées par une incision sur le côté supérieur du disque semi-conducteur ou de substrats similaires, en utilisant une clavette de cassure orientée vers la ligne destinée à la rupture respective à fleur sur le côté inférieur du disque semi-conducteur ou similaire et au moins un bras-support qui s'appuie sur le côté supérieur du disque semi-conducteur ou similaire et déclenche une contre-pression au moment où la clavette de cassure s'appuie sur le côté inférieur du disque semi-conducteur ou similaire,
**caractérisé en ce que** des grandeurs de réglage individuelles pour la clavette de cassure sont générées pour le substrat respectif à partir de ses données caractéristiques spécifiques au substrat, mémorisées au préalable et qu'un choix est effectué en fonction des données caractéristiques spécifiques au substrat entre un mode avec une pression d'appui pour la clavette de cassure constante pour toutes les lignes destinées à la rupture et un mode avec des valeurs de pression d'appui variables individuelles pour chacune des lignes destinées à la rupture individuelles.

2. Procédé selon la revendication 1, **caractérisé en ce que** la pression d'appui est variable en continu et/ou progressivement.

3. Procédé selon la revendication 2, **caractérisé en ce que** la pression d'appui est générée en au moins deux phases de choc décalées dans le temps.

4. Procédé selon la revendication 3, **caractérisé en ce qu'**une pause pouvant être prédéfinie dans le temps a lieu entre deux phases de choc.

5. Procédé selon l'une quelconque des revendications précédentes, **caractérisé en ce que** la pression d'appui est réglable de manière variable en fonction de grandeurs de réglage associées à la ligne destinée à la rupture respective en fonction de la longueur respective de la ligne destinée à la rupture.

6. Procédé selon la revendication 5, **caractérisé en ce que** la pression d'appui est réglable, à partir d'une valeur de pression de base fixée pour la ligne destinée à la rupture la plus courte, sur une valeur supérieure variable pour la ligne destinée à la rupture respectivement suivante en fonction de grandeurs de réglage modifiées.

7. Procédé selon la revendication 6, **caractérisé en ce que** pour des surfaces de substrat rondes, la pression d'appui est réglable, en partant de la valeur de pression de base, progressivement sur des valeurs supérieures en cas de longueur croissante des lignes destinées à la rupture et en conséquence de nouveau sur des valeurs inférieures après une valeur maximale atteinte en cas de longueur de nouveau décroissante.

8. Dispositif de cassure de disques semi-conducteurs ou de plaquettes, disques céramiques et en verre ou substrats similaires sur des lignes destinées à la rupture s'étendant chacune le long d'une droite qui sont marquées par une incision sur le côté supérieur du disque semi-conducteur ou de substrats similaires, en utilisant une clavette de cassure orientée vers la ligne destinée à la rupture respective à fleur sur le côté inférieur du disque semi-conducteur ou similaire et au moins un bras-support qui s'appuie sur le côté supérieur du disque semi-conducteur ou similaire et déclenche une contre-pression au moment où la clavette de cassure s'appuie sur le côté inférieur du disque semi-conducteur ou similaire,
**caractérisé par** un agencement pour détecter et transformer des données caractéristiques spécifiques au substrat et par un dispositif de commande pouvant commuter en fonction de grandeurs de réglage dérivées de données caractéristiques pour la clavette de cassure de telle sorte que la pression d'appui pour la clavette de cassure est réglable d'un côté sur une valeur constante pour toutes les lignes destinées à la rupture et de l'autre côté sur des valeurs variables pour des lignes destinées à la rupture respectives.

9. Dispositif selon la revendication 8, **caractérisé en ce que** substrat et clavette de cassure sont logés de manière mobile l'un par rapport à l'autre dans des étapes prédéfinies par l'écart entre des lignes destinées à la rupture voisines.

10. Dispositif selon la revendication 8 ou 9, **caractérisé en ce que** des agencements de mesure et/ou des capteurs correspondants, qui sont logés par rapport au mouvement relatif entre substrat et clavette de cassure de sorte qu'ils sont chacun orientés vers la ligne destinée à la rupture actuelle, sont prévus pour la détermination des données de mesure spécifiques au substrat.
